# EUROPÄISCHE PATENTSCHRIFT

(11) **EP 3 862 121 B1**
(45) Veröffentlichungstag und Bekanntmachung des Hinweises auf die Patenterteilung: **14.10.2026**
(21) Anmeldenummer: 21151048.2
(22) Anmeldetag: 12.01.2021
(51) Int. Cl.: B23K 1/00, H05K 3/34, B23K 1/005, B23K 1/06, B23K 1/19, B23K 1/20, H05K 1/02, B23K 101/42, B23K 103/10, B23K 103/00

(54) **SCHALTUNGSTRÄGERPLATTE UND VERFAHREN ZUM HERSTELLEN EINER SCHALTUNGSTRÄGERPLATTE**
CIRCUIT CARRIER PLATE AND METHOD OF MAKING A CIRCUIT CARRIER PLATE
PLAQUE PORTE-CIRCUIT ET PROCÉDÉ DE FABRICATION D'UNE PLAQUE PORTE-CIRCUIT

(30) Priorität: 05.02.2020 DE 102020102938
(43) Veröffentlichungstag der Anmeldung: 11.08.2021
(73) Patentinhaber: Marelli Germany GmbH, 72760 Reutlingen (DE)
(72) Erfinder: Schöning, Michael, 37154 Northeim (DE)
(74) Vertreter: DREISS Patentanwälte PartG mbB

(56) Entgegenhaltungen:
- DE-A1- 102012 014 711
- DE-A1- 19 827 014
- DE-T2- 69 211 850
- JP-A- 2008 270 609
- US-A1- 2005 133 934
- US-A1- 2010 123 164
- US-A1- 2012 007 076
- US-A1- 2015 107 882
- US-A1- 2019 157 535

## Beschreibung

Die Erfindung betrifft ein Verfahren zum Herstellen einer Schaltungsträgerplatte gemäß dem Oberbegriff des Anspruchs 1.

Die Erfindung betrifft weiter eine Schaltungsträgerplatte gemäß dem Oberbegriff des Anspruchs 15.

Aus der DE 10 2006 034 425 A1 ist ein Leistungs-LED-Modul bekannt, das einen zur Kühlung der LED vorgesehenen Kühlkörper aus Metall aufweist.

Aus der US 2015/107882 A1 (Basis für den Oberbegriff des Anspruchs 1), JP 2008 270609 A, US 2012/007076 A1 und US 2010/123164 A1 sind Baugruppen bekannt, bei denen bei einer Trägerplatte aus Aluminium oder einer Aluminiumlegierung in einer Ausnehmung oder auf einer Erhebung ein ein Keramikmaterial aufweisender Einsatz angeordnet und mittels einer Lötverbindung mit der Trägerplatte verbunden ist.

Das erfindungsgemäße Verfahren umfasst die folgenden Schritte: Bereitstellen einer Trägerplatte aus Aluminium oder einer Aluminiumlegierung, mit einer Ausnehmung, Anordnen von Lotmaterial in der Ausnehmung und/oder wenigstens einer Erhebung; Anordnen eines wenigstens ein Keramikmaterial aufweisenden Einsatzes in der Ausnehmung und/oder auf der wenigstens einen Erhebung der Trägerplatte;
Bereitstellen einer auf den Einsatz in Richtung einer Grundfläche der Ausnehmung und/oder, insbesondere senkrecht, in Richtung der wenigstens einen Erhebung wirkenden Anpresskraft, und Zuführen von Energie zum Herstellen einer Lötverbindung bei einer Temperatur von 380 bis 420 Grad Celsius, wobei die Trägerplatte beim Herstellen der Lötverbindung mechanisch schwingt.

Erfindungsgemäß umfasst das Anordnen von Lotmaterial das Anordnen eines Röhrenlot-Abschnitts oder Lot-Plättchen in der Ausnehmung und/oder auf der Erhebung.

Gemäß einer vorteilhaften Ausführungsform erfolgt das, insbesondere flächenmäßige, Zuführen von Energie zum Herstellen einer Lötverbindung mittels eines Lasers, insbesondere Galvoscanners.

Gemäß einer weiteren vorteilhaften Ausführungsform erfolgt das Bereitstellen einer auf den Einsatz in Richtung einer Grundfläche der Ausnehmung wirkenden Anpresskraft und/oder das Zuführen von Energie zum Herstellen einer Lötverbindung mittels eines Thermodenlötverfahrens. Vorteilhafterweise kann auf diese Weise sowohl die Antriebskraft als auch die benötigte Energie und gegebenenfalls eine mechanische Schwingung über einen Thermodenlötkopf bereitgestellt werden.

Gemäß einer weiteren vorteilhaften Ausführungsform erfolgt das Zuführen von Energie mittels eines Ultraschall-Lötkolbens.

Gemäß einer vorteilhaften Ausführungsform ist vorgesehen, dass die Ausnehmung ein Durchbruch ist.

Vorteilhafterweise erfolgt die Zufuhr von Energie und/oder Lotmaterial von einer Unterseite, insbesondere durch den Durchbruch hindurch, auf den das Keramikmaterial aufweisenden Einsatz. Auf diese Weise kann von der Unterseite der auf den das Keramikmaterial aufweisenden Einsatz sowohl mit Energie- und Lotmaterialzufuhr als auch mechanischer Reibung eine Lötverbindung hergestellt werden.

In Weiterbildung dieses Erfindungsgedankens erweist es sich als vorteilhaft, wenn das Anordnen von Lotmaterial in dem Durchbruch mittels Zuführen einer Lötdrahtrolle erfolgt.

Gemäß einer vorteilhaften Ausführungsform umfasst das Verfahren weiter einen Schritt zum Vorwärmen, insbesondere induktiven Vorwärmen, der Trägerplatte.

Gemäß einer vorteilhaften Ausführungsform umfasst das Verfahren weiter einen Schritt zum Anordnen einer Leiterplatte auf der Trägerplatte. Eine solche Leiterplatte umfasst beispielsweise einen Faserverbundwerkstoff, insbesondere FR4, oder einen Kunststoff, insbesondere Polyimid. Die Leiterplatte dient beispielsweise als Träger für elektronische Bauteile und/oder als elektrischer Kontakt zu dem das Keramikmaterial aufweisende Einsatz.

Gemäß einer Ausführungsform umfasst das Verfahren weiter einen Schritt zum Verbinden der Leiterplatte mit der Trägerplatte. Das Verbinden der Leiterplatte mit der Trägerplatte erfolgt beispielsweise als mechanische Verbindung, beispielsweise mittels einer Schraubverbindung. Es sind jedoch auch weitere Verbindungsarten denkbar.

Gemäß einer Ausführungsform umfasst das Verfahren weiter einen Schritt zum Verbinden der Leiterplatte mit dem Einsatz. Das Verbinden der Leiterplatte mit dem Einsatz erfolgt vorteilhafterweise als elektrisch leitende Verbindung, beispielsweise als Lötverbindung. Zu diesem Zweck umfassen die Leiterplatte und der Einsatz vorteilhafterweise geeignete elektrische Anschlussstellen. Diese Art von Anschlussstellen mit Durchkontaktierung sind auch unter der Bezeichnung Kantengalvanik bekannt. Details zur Kantengalvanik sind in der DE 10 2014 225 077 A1 der Anmelderin beschrieben.

Gemäß einer Ausführungsform umfasst das Verfahren weiter einen Schritt zum Anordnen eines, insbesondere elektronischen, Bauteils auf dem Einsatz und einen Schritt zum Verbinden des Einsatzes mit dem Bauteil. Zu diesem Zweck umfasst der Einsatz vorteilhafterweise geeignete elektrische Anschlussstellen zum Verbinden mit dem Bauteil.

Weitere Merkmale, Anwendungsmöglichkeiten und Vorteile weiterer bevorzugter Ausführungsformen ergeben sich aus der nachfolgenden Beschreibung und den Figuren der Zeichnung. Dabei bilden alle beschriebenen und dargestellten Merkmale für sich oder in beliebiger Kombination den Gegenstand der Erfindung im Rahmen der offenbarten Ansprüche.

Gleiche und/oder funktionsgleiche Elemente sind in den Figuren mit gleichen Bezugszeichen versehen.

In der Zeichnung zeigt:
Fig. 1 schematisch eine Explosivdarstellung einer
   erfindungsgemäßen Schaltungsträgerplatte gemäß einer bevorzugten Ausführungsform,
Fig. 2 schematisch eine Schnittansicht einer erfindungsgemäßen Schaltungsträgerplatte in einem ersten Zustand;
Fig. 3 schematisch eine Schnittansicht einer erfindungsgemäßen Schaltungsträgerplatte in einem zweiten Zustand, und
Fig. 4 ein vereinfachtes Flussdiagramm eines Verfahrens gemäß einer bevorzugten Ausführungsform.

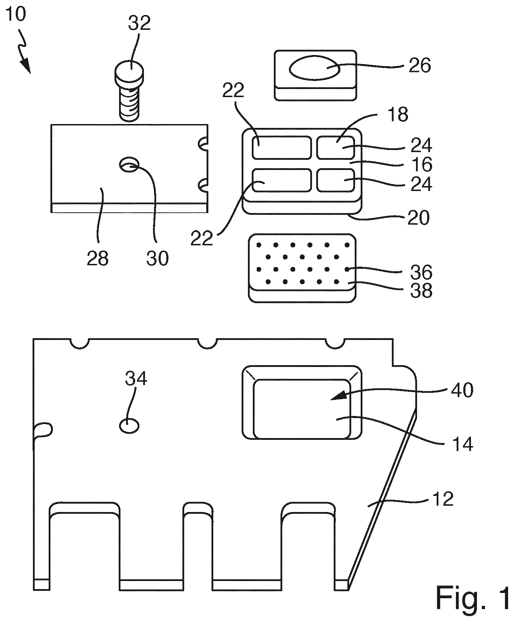

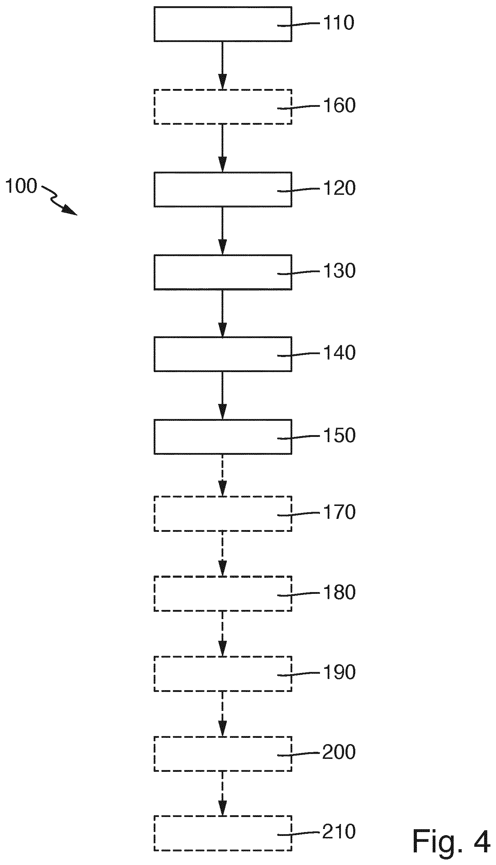

Fig. 1 zeigt schematisch eine Explosivdarstellung einer erfindungsgemäßen Schaltungsträgerplatte gemäß einer bevorzugten Ausführungsform. Die Schaltungsträgerplatte ist in Gesamtheit mit dem Bezugszeichen 10 gekennzeichnet. Die in Figur 1 dargestellten einzelnen Elemente der Schaltungsträgerplatte 10 können gemäß einem Verfahren, das im Weiteren unter Bezugnahme auf Figur 4 erläutert wird, miteinander verbunden werden.

Die Schaltungsträgerplatte 10 umfasst eine Trägerplatte 12.

Die Trägerplatte 12 ist beispielsweise ein Kühlkörper. Die Trägerplatte 12 umfasst Aluminium oder eine Aluminiumlegierung.

Gemäß der dargestellten Ausführungsform umfasst die Trägerplatte 12 eine Ausnehmung 14. Die Ausnehmung 14 kann beispielsweise in einem Umformverfahren, insbesondere Tiefziehverfahren, insbesondere in Form einer Sicke, gefertigt werden. Weiter kann die Ausnehmung 14 in einem materialabtragenden Fertigungsverfahren oder gegebenenfalls bereits in einem Gießverfahren zur Herstellung der Trägerplatte 12 hergestellt werden.

Bei der Ausnehmung 14 kann es sich insbesondere um einen Durchbruch handeln.

Die Schaltungsträgerplatte 10 umfasst einen Einsatz 16. Der Einsatz 16 umfasst ein Keramikmaterial, z.B. aus der Gruppe C700 der Aluminiumoxide oder aus der Gruppe C900 der Aluminiumnitride. Gemäß der dargestellten Ausführungsform umfasst der Einsatz 16 eine erste Metallschicht 18 und eine zweite Metallschicht 20. Die erste Metallschicht 18 ist gemäß der dargestellten Ausführungsform eine strukturierte Metallschicht und umfasst mehrere Anschlussstellen 22, 24.

Gemäß der dargestellten Ausführungsform ist ein, insbesondere elektronisches, Bauteil 26 vorgesehen. Das Bauteil 26 ist beispielsweise eine LED. Das Bauteil 26 kann, beispielsweise über die Anschlussstellen 22,24, mit dem Einsatz 16 verbunden werden.

Gemäß der dargestellten Ausführungsform ist eine Leiterplatte 28 vorgesehen. Die Leiterplatte 28 kann, beispielsweise über die Anschlussstellen 22, mit dem Einsatz 16 verbunden werden. Gemäß der dargestellten Ausführungsform umfasst die Leiterplatte 28 eine Durchgangsbohrung 30. Die Leiterplatte 28 kann beispielsweise mittels einer Schraube 32 und über eine korrespondierende Bohrung 34 in der Trägerplatte 12 mit der Trägerplatte 12 verbunden werden.

Gemäß der dargestellten Ausführungsform ist weiter ein Lotmaterial 36 vorgesehen. Das Lotmaterial 36 ist gemäß der dargestellten Ausführungsform auf einem Lot-Plättchen 38 angeordnet. Das Lotmaterial 36 umfasst vorteilhafterweise ein Speziallötzinn, umfassend Alu und Zink. Dieses Lötzinn fließt bei ca. 380 - 420 Grad Celsius. Dieser Temperaturbereich stellt den Übergang von Weichlöten zur Hartlöten dar.

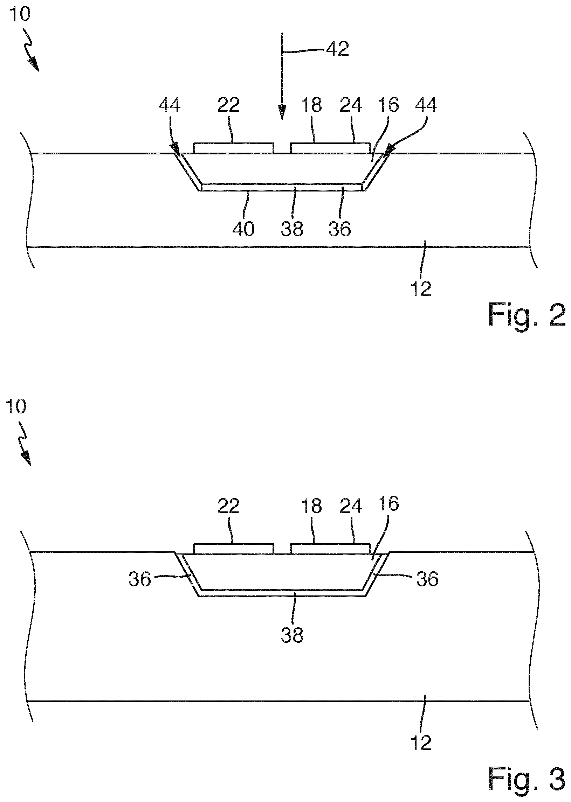

Ein Verfahren 100 zum Herstellen einer Schaltungsträgerplatte 12 wird nun unter Bezugnahme auf die Figuren 2 bis 4 beschrieben.

Das Verfahren 100 umfasst einen Schritt 110 zum Bereitstellen 110 der metallischen Trägerplatte 12 mit der Ausnehmung 14.

Das Verfahren 100 umfasst einen Schritt 120 zum Anordnen des Lotmaterials 36 in der Ausnehmung 14.

Das Verfahren 100 umfasst einen Schritt 130 zum Anordnen des Einsatzes 16 in der Ausnehmung 14.

Das Verfahren 100 umfasst einen Schritt 140 zum Bereitstellen einer auf den Einsatz 16 in Richtung einer Grundfläche 40 der Ausnehmung 14 wirkenden Anpresskraft. Die Wirkungsrichtung der Kraft ist durch den Pfeil 42 in Fig.2 dargestellt.

Das Verfahren 100 umfasst weiter einen Schritt 150 zum, insbesondere flächenmäßige, Zuführen von Energie zum Herstellen einer Lötverbindung. Durch Zuführen von Energie werden Temperaturen von 380 bis 420 Grad Celsius erreicht.

Bei diesen Temperaturen kann eine Oxidation des Kupfers auf der Leiterplatte erfolgen. Um dies zu verhindern werden vorteilhafterweise wenigstens einzelne Schritte des Verfahrens unter Schutzgas durchgeführt.

Gemäß der Erfindung ist vorgesehen, dass die Trägerplatte 12 beim Herstellen der Lötverbindung mechanisch schwingt. Durch mechanische Schwingungen kann die dünne Aluminiumoxidschicht der Trägerplatte 12 aufgebrochen werden. Durch die Temperatur von etwa 380-420 Grad Celsius und die mechanischen Schwingungen kann dann Kupfer mit Aluminium verbunden werden.

Das Bereitstellen 140 der Anpresskraft und/oder das Versetzen der Trägerplatte in mechanische Schwingungen erfolgt vorteilhafterweise durch geeignete mechanische Mittel. Beispielsweise kann das Bereitstellen 140 und/oder das Versetzen der Trägerplatte in mechanische Schwingungen auch mittels eines Thermodenlötkopfs erfolgen.

Durch Zuführen 150 von Energie schmilzt das Lotmaterial 36, wobei vorteilhaft der Kapillareffekt nutzbar ist. Der Kapillareffekt sorgt dafür, dass das Lotmaterial 36 in die seitlichen Spalten 44 zwischen dem Einsatz 16 und einem Rand der Ausnehmung 14 eindringt. Aufgrund des Kapillareffekts ist ein Spalt zwischen der Trägerplatte 12 und der Leiterplatte 28 ausreichend. Dieser Spalt kann durch die Ausnehmung 14, insbesondere schlitzförmige Durchbrüche, oder insbesondere mehrere, Erhebungen gebildet werden. Die Erhebungen umfassen insbesondere eine Höhe von 100 µm.

Gemäß einer vorteilhaften Ausführungsform ist die Ausnehmung 14 ein Durchbruch. In diesem Fall kann das Zuführen 150 von Energie und/oder das Anordnen 120 von Lotmaterial 36 von einer Unterseite, insbesondere durch den Durchbruch, auf den das Keramikmaterial aufweisenden Einsatz 16 erfolgen. Vorteilhafterweise erfolgt das Anordnen von Lotmaterial in dem Durchbruch mittels Zuführen einer Lötdrahtrolle und/oder der Eintrag von Energie durch einen Ultraschall-Lötkolben.

Figur 2 zeigt die Schaltungsträgerplatte 10 nach Ausführen der Schritte 110 bis 130. Figur 3 zeigt die Schaltungsträgerplatte 10 nach Ausführen der Schritte 140 und 150.

Gemäß bevorzugten Ausführungsformen umfasst das Verfahren 100 weiter einen Schritt 160 zum Vorwärmen, insbesondere induktives Vorwärmen, der Trägerplatte 12.

Gemäß bevorzugten Ausführungsformen umfasst das Verfahren 100 weiter einen Schritt 170 zum Anordnen der Leiterplatte 28 auf der Trägerplatte 12.

Gemäß bevorzugten Ausführungsformen umfasst das Verfahren 100 weiter einen Schritt 180 zum Verbinden der Leiterplatte 28 mit der Trägerplatte 12. Das Verbinden 180 der Leiterplatte 28 mit der Trägerplatte 12 erfolgt beispielsweise als mechanische Verbindung, beispielsweise mittels der Schraubverbindung 30, 32, 34.

Gemäß bevorzugten Ausführungsformen umfasst das Verfahren 100 weiter einen Schritt 190 zum Verbinden der Leiterplatte 28 mit dem Einsatz 16. Das Verbinden 190 der Leiterplatte 28 mit dem Einsatz 16 erfolgt vorteilhafterweise als elektrisch leitende Verbindung, beispielsweise als Lötverbindung. Die Leiterplatte 28 kann beispielsweise mit den Anschlussstellen 24 des Einsatzes 16 verbunden werden. Das Verbinden kann beispielsweise mittels eines Laserlötverfahrens erfolgen.

Gemäß bevorzugten Ausführungsformen umfasst das Verfahren 100 einen Schritt 200 zum Anordnen des, insbesondere elektronischen, Bauteils 26 auf dem Einsatz 16 und einen Schritt 210 zum Verbinden des Einsatzes 16 mit dem Bauteil 26. Das Verbinden 210 erfolgt beispielsweise mittels eines Reflow-Lötverfahrens. Wenn im vorhergehenden Prozess das Verbinden der Leiterplatte 28 mit der Trägerplatte bei Temperaturen von ca. 380 - 420 Grad Celsius hergestellt wurde, kann das Reflow-Verfahren bei Temperaturen von ca. 270 Grad Celsius durchgeführt werden. Auf diese Weise ist ein durchgehender Produktionsfluss beim Herstellen der Schaltungsträgerplatte 10 möglich.

Vorteilhafterweise können mehrere, insbesondere sämtliche, Schritte des Verfahrens 100 mit einer geeigneten Vorrichtung, insbesondere mit einem Lötautomaten, ausgeführt werden.

Bei der Schaltungsträgerplatte 10 handelt es sich beispielsweise um einen Aufbau für eine LED-Modul in einem Kraftfahrzeugscheinwerfer. Die Trägerplatte 12 kann beispielsweise eine gebogene und/oder geschlitzte Aluminiumplatte als Kühlkörper umfassen. Die Leiterplatte 28 umfasst beispielsweise Aluminiumoxid und ist flächig auf der Trägerplatte 12 aufgebracht.

## Patentansprüche

1. Verfahren (100) zum Herstellen einer
Schaltungsträgerplatte (10), aufweisend die folgenden Schritte: Bereitstellen (110) einer Trägerplatte (12) aus Aluminium oder einer Aluminiumlegierung, mit einer Ausnehmung (14) und/oder wenigstens einer Erhebung, Anordnen (120) von Lotmaterial (36) in Form eines Röhrenlot-Abschnitts oder Lot-Plättchens (38) in der Ausnehmung (14) und/oder auf der wenigstens einen Erhebung;
Anordnen (130) eines wenigstens ein Keramikmaterial aufweisenden Einsatzes (16) in der Ausnehmung (14) und/oder auf der wenigstens einen Erhebung der Trägerplatte (12);
Bereitstellen (140) einer auf den Einsatz (16) in Richtung einer Grundfläche (40) der Ausnehmung (14) und/oder, insbesondere senkrecht, in Richtung der wenigstens einen Erhebung wirkenden Anpresskraft, und Zuführen (150) von Energie zum Herstellen einer Lötverbindung der Trägerplatte (12) mit dem Einsatz (16) bei einer Temperatur von 380 bis 420 Grad Celsius, **dadurch gekennzeichnet, dass** die Trägerplatte (12) beim Herstellen der Lötverbindung mechanisch schwingt.

2. Verfahren (100) nach Anspruch 1, **dadurch gekennzeichnet, dass** das, insbesondere flächenmäßige, Zuführen (150) von Energie zum Herstellen einer Lötverbindung mittels eines Lasers erfolgt.

3. Verfahren (100) nach Anspruch 1, **dadurch gekennzeichnet, dass** das Bereitstellen (140) einer auf den Einsatz (16) in Richtung einer Grundfläche (40) der Ausnehmung (14) wirkenden Anpresskraft und/oder das Zuführen (150) von Energie zum Herstellen einer Lötverbindung mittels eines Thermodenlötverfahrens erfolgt.

4. Verfahren nach wenigstens einem der vorhergehenden Ansprüche, **dadurch gekennzeichnet, dass** die Ausnehmung (14) ein Durchbruch ist.

5. Verfahren nach Anspruch **4, dadurch gekennzeichnet, dass** die Zufuhr von Energie und/oder Lotmaterial (36) von einer Unterseite auf den das Keramikmaterial aufweisenden Einsatz (16) erfolgt.

6. Verfahren (100) nach wenigstens einem der Ansprüche 1 oder 4 oder **5, dadurch gekennzeichnet, dass** die Zufuhr von Energie mittels eines Ultraschall-Lötkolbens erfolgt.

7. Verfahren (100) nach wenigstens einem der vorhergehenden Ansprüche, **dadurch gekennzeichnet, dass** das Verfahren (100) weiter umfasst: Vorwärmen (160), insbesondere induktives Vorwärmen, der Trägerplatte (12).

8. Verfahren (100) nach wenigstens einem der vorhergehenden Ansprüche, **dadurch gekennzeichnet, dass** das Verfahren (100) weiter umfasst: Anordnen (170) einer Leiterplatte (28) auf der Trägerplatte (12).

9. Verfahren (100) nach Anspruch 8, **dadurch gekennzeichnet, dass** das Verfahren (100) weiter umfasst: Verbinden (180) der Leiterplatte (28) mit der Trägerplatte (12).

10. Verfahren (100) nach wenigstens einem der Ansprüche 8 oder 9, **dadurch gekennzeichnet, dass** das Verfahren (100) weiter umfasst: Verbinden (190) der Leiterplatte (28) mit dem Einsatz (16).

11. Verfahren (100) nach wenigstens einem der vorhergehenden Ansprüche, **dadurch gekennzeichnet, dass** das Verfahren (100) weiter umfasst: Anordnen (200) eines, insbesondere elektronischen, Bauteils (26) auf dem Einsatz (16) und Verbinden (210) des Einsatzes (16) mit dem, insbesondere elektronischen, Bauteil (26).

## Claims

1. Method (100) for producing a circuit carrier plate (10), comprising the following steps: providing (110) a carrier plate (12) made of aluminum or of an aluminum alloy and having a recess (14) and/or at least one protrusion, arranging (120) solder material (36) in the form of a tubular solder portion or solder platelet (38) in the recess (14) and/or on the at least one protrusion;
arranging (130) an insert (16) comprising at least one ceramic material in the recess (14) and/or on the at least one protrusion of the carrier plate (12);
providing (140) a contact pressure on the insert (16) in the direction of a base surface (40) of the recess (14) and/or, in particular perpendicularly, in the direction of the at least one protrusion, and supplying (150) energy to produce a soldered joint between the carrier plate (12) and the insert (16) at a temperature of 380 to 420 degrees Celsius, **characterized in that** the carrier plate (12) vibrates mechanically while the soldered joint is being produced.

2. Method (100) according to claim 1, **characterized in that** energy for producing a soldered joint is supplied (150) over the surface by means of a laser.

3. Method (100) according to claim 1, **characterized in that** a contact pressure acting on the insert (16) in the direction of a base surface (40) of the recess (14) is provided (140) and/or energy for producing a soldered joint is supplied (150) by means of a thermode soldering method.

4. Method according to at least one of the preceding claims, **characterized in that** the recess (14) is an opening.

5. Method (100) according to claim 4, **characterized in that** energy and/or solder material (36) is supplied from a lower side onto the insert (16) comprising the ceramic material.

6. Method (100) according to at least one of claims 1 or 4 or 5, **characterized in that** energy is supplied by means of an ultrasonic soldering iron.

7. Method (100) according to at least one of the preceding claims, **characterized in that** the method (100) further comprises: preheating (160), in particular inductively preheating, the carrier plate (12).

8. Method (100) according to at least one of the preceding claims, **characterized in that** the method (100) further comprises: arranging (170) a printed circuit board (28) on the carrier plate (12).

9. Method (100) according to claim 8, **characterized in that** the method (100) further comprises: connecting (180) the printed circuit board (28) to the carrier plate (12).

10. Method (100) according to at least one of claims 8 or 9, **characterized in that** the method (100) further comprises: connecting (190) the printed circuit board (28) to the insert (16).

11. Method (100) according to at least one of the preceding claims, **characterized in that** the method (100) further comprises: arranging (200) an, in particular electronic, component (26) on the insert (16) and connecting (210) the insert (16) to the, in particular electronic, component (26).

## Revendications

1. Procédé (100) de fabrication d'une plaque porteuse de circuit (10), comprenant les étapes suivantes: fournir (110) une plaque porteuse (12) en aluminium ou en un alliage d'aluminium, présentant un creux (14) et/ou au moins une saillie, disposer (120) du matériau de brasage (36) sous forme d'une section de métal d'apport de brasage tubulaire ou d'une plaque de métal d'apport de brasage (38) dans ledit creux (14) et/ou sur ladite au moins une saillie;
disposer (130) un insert (16) présentant au moins un matériau céramique, dans le creux (14) et/ou sur ladite au moins une saillie de la plaque porteuse (12);
fournir (140) une force de pression agissant sur l'insert (16) en direction d'une surface de base (40) du creux (14) et/ou, en particulier, perpendiculairement, en direction de ladite au moins une saillie, et amener (150) de l'énergie afin de réaliser une liaison brasée entre la plaque porteuse (12) et l'insert (16) à une température de 380 à 420°C, **caractérisé en ce que** la plaque porteuse (12) vibre mécaniquement pendant la réalisation de la liaison brasée.

2. Procédé (100) selon la revendication 1, **caractérisé en ce que** l'amenée (150), en particulier en termes de surface, d'énergie pour la réalisation d'une liaison brasée est effectuée au moyen d'un laser.

3. Procédé (100) selon la revendication 1, **caractérisé en ce que** la fourniture (140) d'une force de pression agissant sur l'insert (16) en direction d'une surface de base (40) du creux (14) et/ou l'amenée (150) d'énergie pour la réalisation d'une liaison brasée sont effectués au moyen d'un procédé de brasage thermode.

4. Procédé selon au moins l'une quelconque des revendications précédentes, **caractérisé en ce que** le creux (14) est une percée.

5. Procédé selon la revendication 4, **caractérisé en ce que** l'amenée d'énergie et/ou de matériau de brasage (36) est effectué par une face inférieure sur l'insert (16) présentant le matériau céramique.

6. Procédé (100) selon au moins l'une quelconque des revendications 1 ou 4 ou 5, **caractérisé en ce que** l'amenée d'énergie est effectuée au moyen d'un fer à souder à ultrasons.

7. Procédé (100) selon au moins l'une quelconque des revendications précédentes, **caractérisé en ce que** le procédé (100) comprend en outre: un préchauffage (160), en particulier un préchauffage par induction, de la plaque porteuse (12).

8. Procédé (100) selon au moins l'une quelconque des revendications précédentes, **caractérisé en ce que** le procédé (100) comprend en outre: la disposition (170) d'une carte de circuit imprimé (28) sur la plaque porteuse (12).

9. Procédé (100) selon la revendication 8, **caractérisé en ce que** le procédé (100) comprend en outre: la connexion (180) de la carte de circuit imprimé (28) à la plaque porteuse (12).

10. Procédé (100) selon au moins l'une quelconque des revendications 8 ou 9, **caractérisé en ce que** le procédé (100) comprend en outre: la connexion (190) de la carte de circuit imprimé (28) à l'insert (16).

11. Procédé (100) selon au moins l'une quelconque des revendications précédentes, **caractérisé en ce que** le procédé (100) comprend en outre: la disposition (200) d'un composant (26), en particulier électronique, sur l'insert (16) et la connexion (210) de l'insert (16) au composant (26), en particulier électronique.
